# EUROPEAN PATENT SPECIFICATION

(11) **EP 4 341 592 B1**
(45) Date of publication and mention of the grant of the patent: **04.12.2024**
(21) Application number: 22736018.7
(22) Date of filing: 16.05.2022
(51) Int. Cl.: F16K 31/06, F16K 37/00, F16K 31/42

(54) **DETECTION OF SAFE ACTIVATION OF SHUTDOWN VALVES AND BLOWDOWN VALVES**
DETEKTION DER SICHEREN AKTIVIERUNG VON ABSPERRVENTILEN UND ABBLASVENTILEN
DÉTECTION D'ACTIVATION SÛRE DE SOUPAPES D'ARRÊT ET DE SOUPAPES DE PURGE

(30) Priority: 18.05.2021 NO 20210616
(43) Date of publication of application: 27.03.2024
(73) Proprietor: IDEATION AS, 4072 Randaberg (NO)
(72) Inventor: DYRDAL, Knut Are, 5397 BEKKJARVIK (NO)
(74) Representative: AWA Norway AS
(86) International application number: PCT/NO2022/050109
(87) International publication number: WO 2022/245221

(56) References cited:
- EP-A1- 1 643 323
- US-A1- 2018 045 375
- US-A1- 2020 182 377

## Description

### FIELD OF THE INVENTION

The present invention relates to a system and method to detect failure to de-energize ON/OFF valve actuators, especially around ESD/PSD/BD valve failure to de-energize without interfering/degrading the safety integrity of the Shutdown Valve, (SDV) defined as a Final Control Element in the Safety Instrumented System (SIS) (IEC61508, IEC 6151or the PSA).

### BACKGROUND

A Shutdown Valve, SDV (also referred to as Process Shutdown Valve (PSDV) or Emergency Shutdown Valve (ESV) or Emergency Shut Down Valve (ESDV)) is an actuated ON/OFF valve designed to stop the flow of a hazardous fluid upon the detection of a dangerous event. SDVs are energized to open in normal operation and de-energized close when required by the process. Blow Down Valves (BDV) are actuated ON/OFF valves designed to depressurize a process system in case of a detected hazardous situation on the plant. BDV's are energized shut in normal operations and de-energize to open when a process blow-down is required.

SDV's and BDV's are examples of general ON/OFF valves used in a variety of industrial application to safeguard process equipment for exposure of internal pressures exceeding the equipment design pressure, among others the oil and gas industry.

To simplify the description of this invention ON/OFF valve, energized in normal operation and de-energized to safeguard the process, are used in the following, but the description is equally valid for SDV's and BDV's.

In the process industry the Process Control System (PCS) will ensure stable production and processing during normal operation. The Safety Instrumented System (SIS) will respond in case of a failure of the PCS such as instrument faults, or in case of a hazardous event not managed by the PCS such as an external equipment faults, gas leaks, fires etc.

The Safety Instrumented System (SIS) normally consist of several independent systems, the Process ShutDown (PSD) system, and the Emergency ShutDown (ESD) system including the Fire &Gas (F&G) system.

For both technical and financial reasons, an SDV can be activated by both ESD and PSD independent of each other, and to allow a graceful start-up of the process and for the purpose of system synchronization, the Process Control System (PCS) is also interfaced to the SIS logic systems and the activation of SDVs.

All of the international safety regulations (PSA regulations, IEC 61508/61511 and ISO 10148) include requirements related to independence between systems comprising the SIS, i.e. ESD, PSD and PCS. Such requirements are introduced as a defence against making several barriers vulnerable to one common event or cause, and to avoid negative effects from one function onto another.

IEC 61508 classifies the frequencies of demands of the SIS into three different demand modes. Low-demand which would occur less than once per year, high-demand occur more than once per year and continuous-mode are always present.

The safety integrity of the SIS is the probability to satisfactorily performing the required safety functions under all the stated conditions within a stated period.

SDV's are Final Control Elements in the SIS to manage functional safety to the process, or the Equipment Under Control (EUC) to protect people, environment, and the economical investments against possible harm, upon the detection of a hazardous event.

However, for some applications, for example when the pneumatic or hydraulic actuated SDV is the Final Control Element in the EUC, a normally used configuration is to operate the SDV actuator from independent solenoid valves controlled by the ESD and the PSD system in the SIS. In some applications a third solenoid valve controlled by the DCS system is connected to the mentioned SDVs.

For the process industry the low-demand mode of the SIS means that a failed state is not hazardous unless a demand occurs. By nature of the faults some may remain hidden until a demand occurs, at which time the SIS will not be able to execute the safeguarding action on the EUC. These faults are defined as Dangerous Undetected (DU) faults. DU faults can be detected by proof tests. A shutdown test will reveal if SDVs are closing or not. However, when both ESD, PSD and DCS are energizing individual solenoid valves to supply fluid (air/hydraulic) to on the SDV actuator, a simple shutdown test of the SDV will not reveal which solenoid valve have failed, since all systems will act on a general shutdown. A Dangerous Undetected fault in any individual solenoid valve connected to the ESD system or the PSD system will jeopardize the safety function of that system, and therefore also the overall safety of the EUC.

A system according to the preamble of independent claim 1 is known from EP1643323A1.

### SUMMARY

To solve the above-mentioned problems and to satisfy the above-mentioned need, in accordance with the present invention it is provided a detector system to detect or determine at least a solenoid valve failure to de-energize the ON/OFF valve actuator, the specialty of the detector system is that it comprises
- at least one detector which monitor if a solenoid valve is energized or de-energized, and at least one detector which monitor if a solenoid valve has closed and properly and vented the fluid to de-energize the ON/OFF valve actuator and at least one detector that monitor if the ON/OFF valve actuator is energized or not
- a controller that connects to the said detectors to detect and evaluate if any dangerous solenoid valve failure occurs
- a method and system to detect correlation between electric de-energizing a solenoid valve and the vent of air or fluid from the same solenoid valve.
- a method and system to increase overall system availability by failure detection and thereby reduce testing and maintenance work.
- a method and system to generate and store fault messages related to electric de-energizing a solenoid valve and the vent of air or fluid from the same solenoid valve in real time in the local Predictor microcontroller and transmit the messages wireless as required by external operational data systems.

These objectives are achieved with the method and system of the present invention as set forth in the appended claims.

### BRIEF DESCRIPTION OF THE DRAWINGS

The invention will now be described in more detail and with reference to the appended drawings, in which:
Fig.1 illustrates system communication in the inventive system,
Fig.2 shows the placement of process components, sensors, and processor,
Fig.3 is a flow chart of solenoid valve operation and failure detection, and
Fig 4 is a table showing solenoid states and solenoid valve faults.

### DETAILED DESCRIPTION OF THE INVENTION

At least one embodiment of the present invention is described below about operation of ON/OFF valves with pneumatic or hydraulic activation system within an oil and gas production plant. However, it should be apparent to those skilled in the art and guided by the teaching herein that the present invention is likewise applicable to any Emergency ShutDown Valves (ESDV's) with either pneumatic or hydraulic activation system and any, Blow Down Valves (BDV's) in any industrial facility that may employ SDV's, ESDV's or BDV's.

A non-exhaustive listing of possible industrial facilities that employ ON/OFF valves, SDV's, ESDV's or BDV's and have a need to monitor such valves includes power generation plants, chemical facilities and electrical facilities. Those skilled in the art will further recognize that the teachings herein are suited to other applications in addition to industrial settings such as for example military, commercial and residential applications.

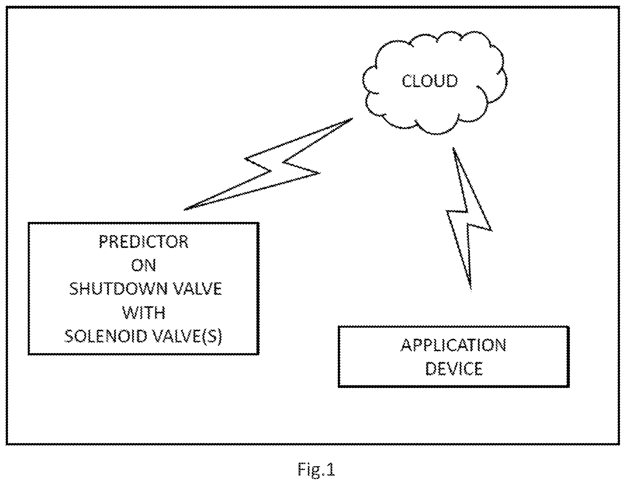

Referring to the drawings FIG. 1, is a schematic illustration of a Shut Down Valve solenoid valve(s) activation system depicting the communication as a generic symbol, achieved either over a Wi-Fi network, Bluetooth protocol, SMS protocol (a Cloud, dedicated Application, or a Handheld Device), or any other applicable method according to the present invention, also including cabled connections. This setup allows ON/OFF valves such as SDV's and/or BDV's with sensors and the Predictor 50 to communicate with different applications and or devices.

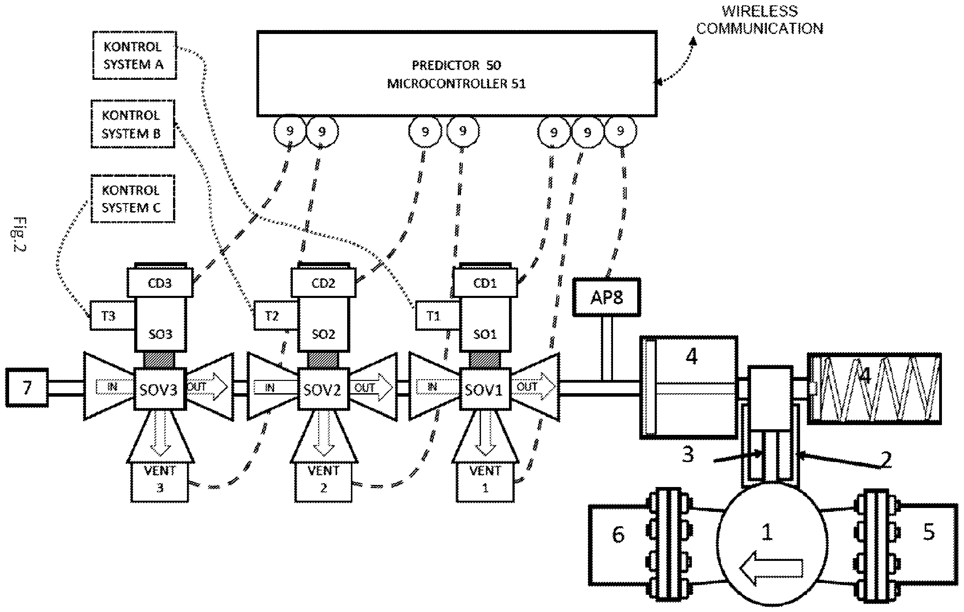

Referring to FIG. 2 where the on/off valve (V1) with an actuator 4 fixed to V1 by mechanical arrangement 2, where the actuator 4 energized by a fluid medium, which may be air, gas or a liquid moves the stem 3 connected to the flow-controlling element in V1 between open and closed position by the actuator 4 to let process medium pass from inlet pipe 5 to outlet pipe 6 in said open position or to stop said process medium passing from inlet pipe 5 to outlet pipe 6 in said closed position, where the actuator 4 is connected to a fluid line 7, acting as a fluid power supply, through a solenoid valve assembly unit comprising at least one solenoid valve which may be direct or indirect (pilot) operated by a solenoid, and where the solenoid valve fluid connections are characterised by one input port, one output port and one vent port, and where the solenoid valve can have at least two operating states, which may be energized or de-energized, where in the energized state the valve input and output port are connected for fluid flow and the vent port is closed and in the de-energized state the output port and the vent port are connected for fluid flow and the input port is closed. The de-energized state should bring the valve to a safe position, i.e. where the associated plant or equipment is being closed down.

For the purpose of describing one embodiment of the invention illustrated schematically in FIG 2 where V1 is defined in de-energised safe position when closed, when the actuator 4 de-energized, three solenoid valve SOV1, SOV2 and SOV3 are included in the solenoid valve assembly where solenoid valve SOV1 and solenoid SO1 through terminal T1 is electric energized or de-energized from external control system A, and where solenoid valve SOV2 and solenoid SO2 through terminal T2 is electric energized or de-energized from external control system B, and where solenoid valve SOV3 and solenoid SO3 through terminal T3 is electric energized or de-energized from external control system C.

When all solenoid valve SOV1, SOV2 and SOV3 are energized the fluid line 7 pressurizes valve actuator 4 to keep the V1 flow controlling element in open position, but if one of the solenoid valve SOV1, SOV2 or SOV3 are de-energized the valve actuator 4 is de-energized and V1 flow controlling element goes to closed position, and where an actuator energized/deenergized detector which may be pressure sensor AP8 monitor the said actuator state.

The solenoid valves SOV1, SOV2 and SOV3 are equipped with solenoid energizing detectors which may be current detectors CD1, CD2 and CD3 which will detect when any of the solenoids SO1, SO2 and SO3 are magnetized or not to confirm that the said solenoid valves are energized or not, and solenoid valve deenergizing detectors which may be fluid flow detectors/valve vent detectors VENT1, VENT2 and VENT3, which will detect if any of the solenoid valve SOV1, SOV2 or SOV3 have changed from energized to de-energized state.

Referring to drawing fig 2, an important element of the invention is the predictor 50, which communicates with the sensors through interfaces 9, and which also includes a microcontroller 51, programmed to compute logic sequences, store data and to read hardwired sensor data from the said solenoid valve assembly sensors including but not limited to:
- VENT 1 detecting air/hydraulic vent flow from SOV1 exhaust port
- CD1 detecting current or no current in SO1 solenoid.
- VENT 2 detecting air/hydraulic vent flow from SOV2 exhaust port
- CD2 detecting current or no current in SO2 solenoid.
- VENT 3 detecting air/hydraulic vent flow from SOV3 exhaust port
- CD3 detecting current or no current in SO3 solenoid
- AP8 monitoring actuator 4 pressure.

Where any of CD1, CD2 or CD3 current detector will generate a signal to trigger the microcontroller 51 to wake up from sleep mode when the current in any solenoid is turned on or off.

One function of the microcontroller 51 is to store defined threshold values for the said hardwired sensors, including pressure, current and flow.

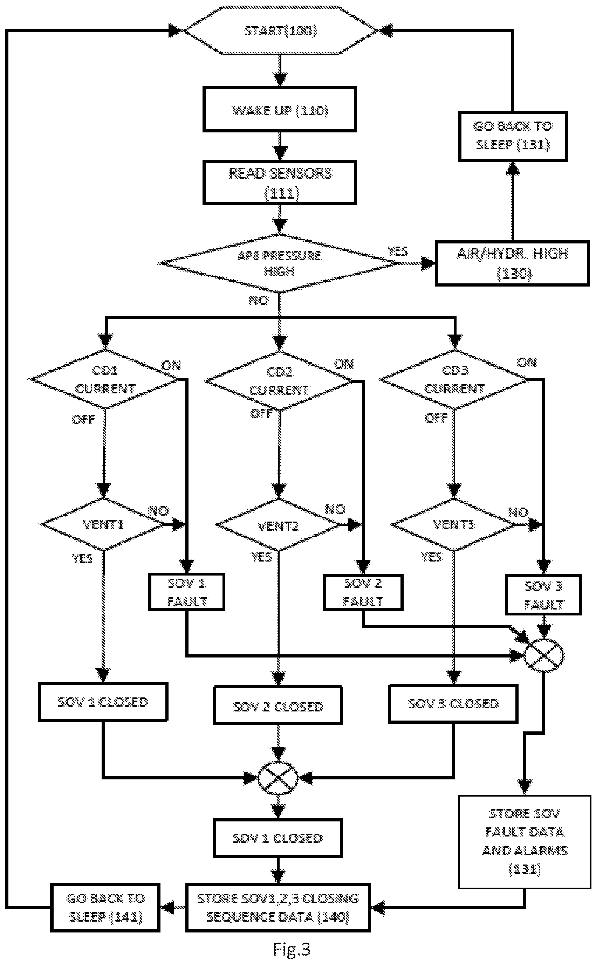

Referring to fig 3 which illustrates the program steps for the microcontroller 51 where start is the initial sleep mod state of the microcontroller 51, and at least one of the current detectors CD1, CD2 or CD3 detect a change in solenoid current, where the wake-up 110 will initiate to read sensors 111 over a programmed period.

If sensor AP8 has an air/hydraulic pressure reading blow a defined threshold, the data from CD1, CD2 and CD3 will document if any of the solenoid valve SOV1, SOV2 and SOV3 is de-energized or not and the microcontroller will correlate the said solenoid valve state with the flow detected in VENT1, VENT2 and VENT3 to determine if any de-energized solenoid valves have not closed as expected, and generate SOV1 FAULT and/or SOV2 FAULT and/or SOV3 FAULT and store solenoid valve fault data and alarms 131.

Similarly, all solenoid valves which are de-energized and vented according to design will be logged together with AP8 low pressure to indicate that the V1 have closed will be logged 140 and the microcontroller 51 will go back to sleep 141.

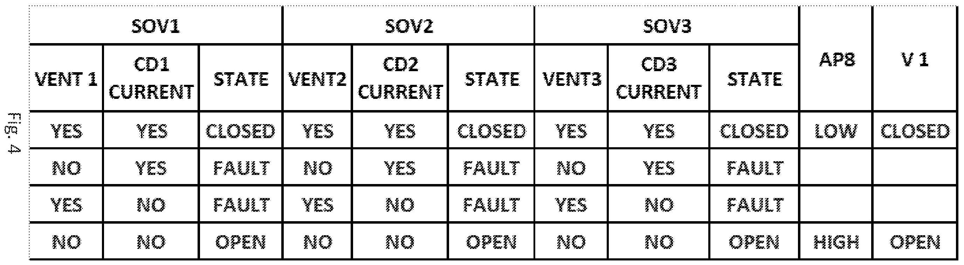

An important element of the present invention is that the microcontroller 51 will store the relationship between system A and SOV1, system B and SOV2 and system C and SOV3 and record and store sequences of low or high pressure of AP8, associated with changes in solenoid valve SOV1, SOV2 and SOV3 open or closed states, deducted from detected above or below set threshold values for solenoid currents CD1, CD2 or CD3 and solenoid valve vent flow VENT1, VENT2 and VENT3 and compare with the correct combination of said pressure and valve states according to table in fig 4, to keep the system operator informed of which of System A,B or C have closed SDV1, and thereby reduce dangerous undetected fault in any one of the said solenoid valves which otherwise would have jeopardize safe closing of V1.

## Claims

1. A system to detect or determine faults in a valve activation system of an on/off valve (V1) including an actuator (4) connected to a pneumatic or hydraulic pressurized fluid line (7), the system including at least one solenoid valve (SOV1, SOV2, SOV3) connected in the fluid line (7) ahead of the actuator (4), wherein each connected solenoid valve (SOV1, SOV2, SOV3) is activated by a solenoid (SO1, SO2, SO3) controlled by an external control system (A, B, C) , said solenoid valves being adapted to block the fluid line (7) when de-activated, and vent the fluid line (7) releasing the pressure from the actuator (4), which will de-energize the actuator (4) and move the on/off valve (V1) to safe position,
**characterized in that** the system further includes
- a current detector (CD1, CD2, CD3) associated with each connected solenoid (SO1, SO2, SO3) monitoring magnetizing current in said solenoid,
- a fluid flow detector (VENT1, VENT2, VENT3) associated with each connected solenoid valve (SOV1, SOV2, SOV3) detecting any flow of fluid vented from the fluid line (7) through the solenoid valve,
- a controller (51) connected to and monitoring signals from each connected current detector (CD1, CD2, CD2) and each connected fluid flow detector (VENT1, VENT2, VENT3).

2. A system according to claim 1, further including a pressure sensor (AP8) measuring the energizing/de-energizing pressure in the fluid line (7) at the actuator (4), said pressure sensor being connected to the controller (51).

3. A system according to claim 1 or 2, wherein the controller (51) is adapted to read and store time series of signals from the current detectors indicating that each connected solenoid valve (SOV1, SOV2, SOV3) being open or closed, and read and store time series of signals from each connected fluid flow detector (VENT1, VENT2, VENT3) detecting if any connected solenoid valve (SOV1, SOV2, SOV3) have vented fluid from the actuator (4) to move the on/off valve (V1) to safe position and evaluate and generate event messages if said detector signals are above or below predetermined measurement limits and determine if said event messages are within a predefined program sequence, and generate alarm if said event message is outside said predefined program sequence.

4. A system according to any of the claims 1-3, wherein said on/off valve (V1) is a shutdown valve (SDV) which in safe position is closed to stop a process medium to pass from an inlet pipe (5) to an outlet pipe (6), or a blowdown valve (BDV) which in safe position is open to release process medium from the inlet pipe (5) to the outlet pipe (6).

5. A system according to any of the claims 1-4, wherein the system is part of a safety instrumented system (SIS).

6. A system according to any of the claims 1-5, wherein the system includes three solenoid valves (SOV1, SOV2, SOV3) connected in series in the fluid line (7) ahead of the actuator (4).

7. A method to detect or to determine failures in the system of claim 1-6,
wherein the method includes:
reading and storing time series of signals from the at least one current detector (CD1, CD2, CD3) indicating that the at least one solenoid valve (SOV1, SOV2, SOV3) being open or closed, and read and store time series of signals from the at least one fluid flow detector (VENT1, VENT2, VENT3) detecting if any solenoid valve (SOV1, SOV2, SOV3) have vented fluid from the actuator (4) to move the on/off valve (V1) to safe position and evaluate and generate event messages if said detector signals are above or below predetermined measurement limits and determine if said event messages are within a predefined program sequence, and generate alarm if said event message is outside said predefined program sequence.

8. A method according to claim 7,
wherein the method includes the procedure of:
a) wake up (110) the controller (51) if detecting in at least one current detector (CD1, CD2, CD3) that magnetizing current is turned on or off from at least one external control system (A, B, C) to at least one solenoid (SO1, SO2, SO3), read and compute time series of readings from the current detectors and fluid flow detectors (110),
b) compare actuator pressure (AP8) with predetermined setting and if pressure is high (130) record that the actuator (4) is energized and the on/off valve (V1) is in operating position, else
c) check that the first solenoid valve (SOV1) is safe closing when the first current detector (CD1) detects no magnetizing current and the first fluid flow detector (VENT1) detects vented fluid, and store that the first solenoid valve (SOV1) is safe closing, or if the first current detector (CD1) detects magnetizing current in the first solenoid (SO1) or the first fluid flow detector (VENT1) detects no vented fluid through the first solenoid valve (SOV1), store first solenoid valve (SOV1) failure,
d) if a second solenoid valve is installed, check that the second solenoid valve (SOV2) is safe closing when the second current detector (CD2) detects no magnetizing current and the second fluid flow detector (VENT2) detects vented fluid, and store that the second solenoid valve (SOV2) is safe closing, or if the second current detector (CD2) detects magnetizing current in the second solenoid (SO2) or the second fluid flow detector (VENT2) detects no vented fluid through the second solenoid valve (SOV2), store second solenoid valve (SOV2) failure,
e) if a third solenoid valve is installed, check that the third solenoid valve (SOV3) is safe closing when the third current detector (CD3 detects no magnetizing current and the third fluid flow detector (VENT3) detects vented fluid, and store that the third solenoid valve (SOV3) is safe closing, or if the third current detector (CD16) detects magnetizing current in the third solenoid (SO3) or the third fluid flow detector (VENT3) detects no vented fluid through the third solenoid valve (SOV3), store third solenoid valve (SOV3) failure,
f) from c), d) and e) read and store solenoid valve failure data, generate solenoid valve failure alarms and generate on/off valve failure alarm to de-energize on command from the external control system A and/or system B and/or system C, else
g) from c), d) and e) store solenoid valve safe closing, store data and generate on/off valve safe de-energize message on command from external control system A and/or system B and/or system C command, else
h) save all relevant data and terminate the procedure.

## Patentansprüche

1. System zum Erkennen oder Bestimmen von Fehlern in einem Ventilaktivierungssystem eines Ein/Aus-Ventils (V1), das ein mit einer pneumatischen oder hydraulischen Druckfluidleitung (7) verbundenes Stellglied (4) aufweist, wobei das System mindestens ein Magnetventil (SOV1, SOV2, SOV3) aufweist, das in der Fluidleitung (7) vor dem Stellglied (4) angeschlossen ist, wobei jedes angeschlossene Magnetventil (SOV1, SOV2, SOV3) durch eine Magnetspule (S01, SO2, SO3) aktiviert wird, die durch ein externes System (A, B, C) gesteuert wird, wobei die Magnetventile so ausgebildet sind, dass sie die Fluidleitung (7) blockieren, wenn sie deaktiviert sind, und die Fluidleitung (7) ventilieren, indem sie den Druck aus dem Stellglied (4) ablassen, wodurch das Stellglied (4) stromlos wird und das Ein/Aus-Ventil (V1) in eine sichere Position gebracht wird,
**dadurch gekennzeichnet, dass** das System ferner Folgendes aufweist:
- einen Stromdetektor (CD1, CD2, CD3), der mit jeder angeschlossenen Magnetspule (S01, SO2, SO3) verbunden ist und den Magnetisierungsstrom in dieser Magnetspule überwacht,
- einen Fluidströmungsdetektor (VENT1, VENT2, VENT3), der mit jedem angeschlossenen Magnetventil (SOV1, SOV2, SOV3) verbunden ist und jede Fluidströmung, die aus der Fluidleitung (7) durch das Magnetventil abgelassen wird, erfasst,
- einen Controller (51), der mit jedem angeschlossenen Stromdetektor (CD1, CD2, CD2) und jedem angeschlossenen Fluidströmungsdetektor (VENT1, VENT2, VENT3) verbunden ist und deren Signale überwacht.

2. System nach Anspruch 1, das ferner einen Drucksensor (AP8) aufweist, der den Einschalt-/Ausschaltdruck in der Fluidleitung (7) am Stellglied (4) misst, wobei der Drucksensor mit dem Controller (51) verbunden ist.

3. System nach Anspruch 1 oder 2, wobei der Controller (51) dazu ausgebildet ist, Zeitreihen von Signalen von den Stromdetektoren zu lesen und zu speichern, die anzeigen, dass jedes angeschlossene Magnetventil (SOV1, SOV2, SOV3) geöffnet oder geschlossen ist, und Zeitreihen von Signalen von jedem angeschlossenen Fluidströmungsdetektor (VENT1, VENT2, VENT3) zu lesen und zu speichern, die erkennen, ob irgendein angeschlossenes Magnetventil (SOV1, SOV2, SOV3) Fluid aus dem Stellglied (4) abgelassen hat, um das Ein/Aus-Ventil (V1) in eine sichere Position zu bewegen, und Ereignismeldungen auszuwerten und zu erzeugen, wenn die Detektorsignale über oder unter vorgegebenen Messgrenzen liegen, und zu bestimmen, ob die Ereignismeldungen innerhalb einer vordefinierten Programmsequenz liegen, und einen Alarm zu erzeugen, wenn die Ereignismeldung außerhalb der vordefinierten Programmsequenz liegt.

4. System nach einem der Ansprüche 1-3, wobei das Ein/Aus-Ventil (V1) ein Absperrventil (SDV) ist, das in sicherer Position geschlossen ist, um den Durchfluss eines Prozessmediums von einer Einlassleitung (5) zu einer Auslassleitung (6) zu stoppen, oder ein Abschlammventil (BDV), das in sicherer Position geöffnet ist, um ein Prozessmedium von der Einlassleitung (5) zu der Auslassleitung (6) freizugeben.

5. System nach einem der Ansprüche 1-4, wobei das System Teil eines sicherheitsgerichteten Systems (SIS) ist.

6. System nach einem der Ansprüche 1-5, wobei das System drei Magnetventile (SOV1, SOV2, SOV3) aufweist, die in der Fluidleitung (7) vor dem Stellglied (4) in Reihe geschaltet sind.

7. Verfahren zum Erkennen oder Bestimmen von Fehlern in dem System nach Anspruch 1-6,
wobei das Verfahren Folgendes beinhaltet:
Lesen und Speichern von Zeitreihen von Signalen von dem mindestens einen Stromdetektor (CD1, CD2, CD3), die anzeigen, dass das mindestens eine Magnetventil (SOV1, SOV2, SOV3) geöffnet oder geschlossen ist, und Lesen und Speichern von Zeitreihen von Signalen von dem mindestens einen Fluidströmungsdetektor (VENT1, VENT2, VENT3), der erkennt, ob irgendein Magnetventil (SOV1, SOV2, SOV3) Flüssigkeit aus dem Stellglied (4) abgelassen hat, um das Ein/Aus-Ventil (V1) in eine sichere Position zu bringen, und Auswerten und Erzeugen von Ereignismeldungen, wenn die Detektorsignale über oder unter vorgegebenen Messgrenzen liegen, und Bestimmen, ob die Ereignismeldungen innerhalb einer vordefinierten Programmsequenz liegen, und Erzeugen eines Alarms, wenn die Ereignismeldung außerhalb der vordefinierten Programmsequenz liegt.

8. Verfahren nach Anspruch 7,
wobei das Verfahren die folgende Prozedur beinhaltet:
a) Aufwecken (110) des Controllers (51), wenn in mindestens einem Stromdetektor (CD1, CD2, CD3) erkannt wird, dass Magnetisierungsstrom von mindestens einem externen System (A, B, C) zu mindestens einer Magnetspule (S01, SO2, SO3) ein- oder ausgeschaltet wird, Lesen und Berechnen von Zeitreihen von Messwerten der Stromdetektoren und Fluidströmungsdetektoren (110),
b) Vergleichen des Stellglieddrucks (AP8) mit der vorgegebenen Einstellung, und wenn der Druck hoch ist (130), Aufzeichnen, dass das Stellglied (4) unter Strom steht und das Ein/Aus-Ventil (V1) in Betriebsstellung ist, sonst
c) Prüfen, ob das erste Magnetventil (SOV1) sicher schließt, wenn der erste Stromdetektor (CD1) keinen Magnetisierungsstrom und der erste Fluidströmungsdetektor (VENT1) abgelassenes Fluid erkennt, und Speichern, dass das erste Magnetventil (SOV1) sicher schließt, oder wenn der erste Stromdetektor (CD1) einen Magnetisierungsstrom in der ersten Magnetspule (SO1) oder der erste Fluidströmungsdetektor (VENT1) kein abgelassenes Fluid durch das erste Magnetventil (SOV1) erkennt, Speichern des Ausfalls des ersten Magnetventils (SOV1),
d) wenn ein zweites Magnetventil installiert ist, Prüfen, ob das zweite Magnetventil (SOV2) sicher schließt, wenn der zweite Stromdetektor (CD2) keinen Magnetisierungsstrom und der zweite Fluidströmungsdetektor (VENT2) abgelassenes Fluid erkennt, und Speichern, dass das zweite Magnetventil (SOV2) sicher schließt, oder wenn der zweite Stromdetektor (CD2) einen Magnetisierungsstrom im zweiten Magnetventil (SO2) oder der zweite Fluidströmungsdetektor (VENT2) kein abgelassenes Fluid durch das zweite Magnetventil (SOV2) erkennt, Speichern des Ausfalls des zweiten Magnetventils (SOV2),
e) wenn ein drittes Magnetventil installiert ist, Prüfen, ob das dritte Magnetventil (SOV3) sicher schließt, wenn der dritte Stromdetektor (CD3) keinen Magnetisierungsstrom und der dritte Fluidströmungsdetektor (VENT3) abgelassenes Fluid erkennt, und Speichern, dass das dritte Magnetventil (SOV3) sicher schließt, oder wenn der dritte Stromdetektor (CD16) einen Magnetisierungsstrom in der dritten Magnetspule (SO3) oder der dritte Fluidströmungsdetektor (VENT3) kein abgelassenes Fluid durch das dritte Magnetventil (SOV3) erkennt, Speichern des Ausfalls des dritten Magnetventils (SOV3),
f) von c), d) und e) Lesen und Speichern von Magnetventil-Ausfalldaten, Erzeugen von Magnetventil-Ausfallalarmen und Erzeugen von Ein/Aus-Ventil-Ausfallalarmen zur Abschaltung auf Befehl des externen Steuersystems A und/oder System B und/oder System C, sonst
g) von c), d) und e) Speichern des sicheren Schließens des Magnetventils, Speichern der Daten und Erzeugen einer Meldung zum sicheren Abschalten des Ein/Aus-Ventils auf Befehl des externen Steuersystems A und/oder des Systems B und/oder des Systems C, sonst
h) Speichern aller relevanten Daten und Beenden der Prozedur.

## Revendications

1. Système de détection ou de détermination de défauts dans un système d'activation de vanne d'une vanne marche/arrêt (V1) comportant un actionneur (4) raccordé à une conduite de fluide (7) sous pression pneumatique ou hydraulique, le système comportant au moins une électrovanne (SOV1, SOV2, SOV3) raccordée à la conduite de fluide (7) en amont de l'actionneur (4), chaque électrovanne (SOV1, SOV2, SOV3) raccordée étant activée par un solénoïde (SO1, SO2, SO3) commandé par un système de commande externe (A, B, C), lesdites électrovannes étant conçues pour bloquer la conduite de fluide (7) lorsqu'elles sont désactivées, et pour évacuer la conduite de fluide (7) en libérant la pression de l'actionneur (4), ce qui désactivera l'actionneur (4) et déplacera la vanne marche/arrêt (V1) en position de sécurité,
**caractérisé en ce que** le système comporte en outre
- un détecteur de courant (CD1, CD2, CD3) associé à chaque solénoïde raccordé (SO1, SO2, SO3) surveillant un courant magnétisant dans ledit solénoïde,
- un détecteur de débit de fluide (VENT1, VENT2, VENT3) associé à chaque électrovanne (SOV1, SOV2, SOV3) raccordée détectant tout débit de fluide évacué de la conduite de fluide (7) à travers l'électrovanne,
- un contrôleur (51) raccordé à et surveillant des signaux de chaque détecteur de courant (CD1, CD2, CD2) raccordé et de chaque détecteur de débit de fluide (VENT1, VENT2, VENT3) raccordé.

2. Système selon la revendication 1, comportant en outre un capteur de pression (AP8) mesurant la pression d'activation/désactivation dans la conduite de fluide (7) au niveau de l'actionneur (4), ledit capteur de pression étant raccordé au contrôleur (51).

3. Système selon la revendication 1 ou 2, dans lequel le contrôleur (51) est conçu pour lire et stocker des séries temporelles de signaux provenant des détecteurs de courant indiquant que chaque électrovanne (SOV1, SOV2, SOV3) raccordée est ouverte ou fermée, lire et stocker des séries temporelles de signaux provenant de chaque détecteur de débit de fluide (VENT1, VENT2, VENT3) raccordé détectant si une quelconque électrovanne (SOV1, SOV2, SOV3) raccordée a évacué du fluide de l'actionneur (4) pour déplacer la vanne marche/arrêt (V1) en position de sécurité et évaluer et générer des messages d'événement si lesdits signaux de détecteur sont supérieurs ou inférieurs à des limites de mesure prédéterminées et déterminer si lesdits messages d'événement se situent dans une séquence de programme prédéfinie, et générer une alarme si ledit message d'événement est en dehors de ladite séquence de programme prédéfinie.

4. Système selon l'une quelconque des revendications 1 à 3, dans lequel ladite vanne marche/arrêt (V1) est une vanne d'extinction (SDV) qui, en position de sécurité, est fermée pour empêcher un milieu de traitement de passer d'un tuyau d'entrée (5) à un tuyau de sortie (6), ou une vanne de purge (BDV) qui, en position de sécurité, est ouverte pour libérer le milieu de traitement du tuyau d'entrée (5) au tuyau de sortie (6).

5. Système selon l'une quelconque des revendications 1 à 4, dans lequel le système fait partie d'un système instrumenté de sécurité (SIS).

6. Système selon l'une quelconque des revendications 1 à 5, dans lequel le système comporte trois électrovannes (SOV1, SOV2, SOV3) raccordées en série dans la conduite de fluide (7) en amont de l'actionneur (4).

7. Procédé pour détecter ou déterminer des défaillances dans le système selon les revendications 1 à 6,
le procédé comprenant :
la lecture et le stockage de séries temporelles de signaux provenant de l'au moins un détecteur de courant (CD1, CD2, CD3) indiquant que l'au moins une électrovanne (SOV1, SOV2, SOV3) est ouverte ou fermée, la lecture et le stockage de séries temporelles de signaux provenant de l'au moins un détecteur de débit de fluide (VENT1, VENT2, VENT3) détectant si une quelconque électrovanne (SOV1, SOV2, SOV3) a évacué du fluide de l'actionneur (4) pour déplacer la vanne marche/arrêt (V1) en position de sécurité et évaluer et générer des messages d'événement si lesdits signaux de détecteur sont supérieurs ou inférieurs à des limites de mesure prédéterminées et déterminer si lesdits messages d'événement se situent dans une séquence de programme prédéfinie, et générer une alarme si ledit message d'événement est en dehors de ladite séquence de programme prédéfinie.

8. Procédé selon la revendication 7,
dans lequel le procédé comporte la procédure suivante :
a) réveiller (110) le contrôleur (51) en cas de détection dans au moins un détecteur de courant (CD1, CD2, CD3) qu'un courant magnétisant est activé ou désactivé à partir d'au moins un système de commande externe (A, B, C) vers au moins un solénoïde (SO1, SO2, SO3), lire et calculer des séries temporelles de lectures provenant des détecteurs de courant et des détecteurs de débit de fluide (110),
b) comparer une pression d'actionneur (AP8) avec un réglage prédéterminé et si la pression est élevée (130) enregistrer que l'actionneur (4) est activé et que la vanne marche/arrêt (V1) est en position de fonctionnement, sinon
c) vérifier que la première électrovanne (SOV1) se ferme de manière sûre lorsque le premier détecteur de courant (CD1) ne détecte aucun courant magnétisant et que le premier détecteur de débit de fluide (VENT1) détecte un fluide évacué, et stocker le fait que la première électrovanne (SOV1) se ferme de manière sûre, ou si le premier détecteur de courant (CD1) détecte un courant magnétisant dans le premier solénoïde (SO1) ou que le premier détecteur de débit de fluide (VENT1) ne détecte aucun fluide évacué à travers la première électrovanne (SOV1), stocker une défaillance de la première électrovanne (SOV1),
d) si une deuxième électrovanne est installée, vérifier que la deuxième électrovanne (SOV2) se ferme de manière sûre lorsque le deuxième détecteur de courant (CD2) ne détecte aucun courant magnétisant et que le deuxième détecteur de débit de fluide (VENT2) détecte un fluide évacué, et stocker le fait que la deuxième électrovanne (SOV2) se ferme de manière sûre, ou si le deuxième détecteur de courant (CD2) détecte un courant de magnétisation dans le deuxième solénoïde (SO2) ou que le deuxième détecteur de débit de fluide (VENT2) ne détecte aucun fluide évacué à travers la deuxième électrovanne (SOV2), stocker une défaillance de la deuxième électrovanne (SOV2),
e) si une troisième électrovanne est installée, vérifier que la troisième électrovanne (SOV3) se ferme de manière sûre lorsque le troisième détecteur de courant (CD3) ne détecte aucun courant magnétisant et que le troisième détecteur de débit de fluide (VENT3) détecte un fluide évacué, et stocker le fait que la troisième électrovanne (SOV3) se ferme de manière sûre, ou si le troisième détecteur de courant (CD16) détecte un courant magnétisant dans le troisième solénoïde (SO3) ou que le troisième détecteur de débit de fluide (VENT3) ne détecte aucun fluide évacué à travers la troisième électrovanne (SOV3), stocker une défaillance de la troisième électrovanne (SOV3),
f) à partir de c), d) et e) lire et stocker des données de défaillance d'électrovanne, générer des alarmes de défaillance d'électrovanne et générer une alarme de défaillance de vanne marche/arrêt pour désactiver sur commande à partir du système de commande externe A et/ou du système B et/ou du système C, sinon
g) à partir de c), d) et e) stocker la fermeture de manière sûre de l'électrovanne, stocker des données et générer un message de désactivation de manière sûre de la vanne marche/arrêt sur commande à partir d'une commande du système de commande externe A et/ou du système B et/ou du système C, sinon
h) enregistrer toutes les données pertinentes et mettre fin à la procédure.
